# FASCICULE DE BREVET EUROPEEN

(11) **EP 2 447 987 B1**
(45) Date de publication et mention de la délivrance du brevet: **11.11.2020**
(21) Numéro de dépôt: 11354058.7
(22) Date de dépôt: 26.10.2011
(51) Int. Cl.: H01L 21/8238, H01L 21/336, H01L 21/76

(54) **Procédé de fabrication d'un substrat muni de deux zones actives avec des matériaux semi-conducteurs différents**
Verfahren zur Herstellung eines Substrats mit zwei aktiven Zonen mit unterschiedlichen Halbleitermaterialien
Method for manufacturing a substrate provided with two active areas with different semi-conductor materials

(30) Priorité: 27.10.2010 FR 1004222
(43) Date de publication de la demande: 02.05.2012
(73) Titulaire: Commissariat à l'Énergie Atomique et aux Énergies Alternatives, 75015 Paris (FR)
(72) Inventeur: Hartmann, Jean-Michel, 38420 Le Versoud (FR)
(74) Mandataire: Talbot, Alexandre

(56) Documents cités:
- EP-A1- 1 231 640
- US-A1- 2007 252 216
- BERA L K ET AL: "A Dual-Strained CMOS Structure Through Simultaneous Formation of Relaxed and Compressive Strained-SiGe-on-Insulator", IEEE ELECTRON DEVICE LETTERS, IEEE SERVICE CENTER, NEW YORK, NY, US, vol. 27, no. 5, 1 mai 2006 (2006-05-01), pages 350-353, XP001546542, ISSN: 0741-3106, DOI: DOI:10.1109/LED.2006.872353
- TEZUKA TSUTOMU ET AL: "Strain analysis in ultrathin SiGe-on-insulator layers formed from strained Si-on-insulator substrates by Ge-condensation process", APPLIED PHYSICS LETTERS, AIP, AMERICAN INSTITUTE OF PHYSICS, MELVILLE, NY, US, vol. 90, no. 18, 2 mai 2007 (2007-05-02), pages 181918-181918, XP012094492, ISSN: 0003-6951, DOI: DOI:10.1063/1.2735672
- JURCZAK M ET AL: "SON (silicon on nothing)-a new device architecture for the ULSI era", 1999 SYMPOSIUM ON VLSI TECHNOLOGY. DIGEST OF TECHNICAL PAPERS (IEEE CAT. NO.99CH36325) JAPAN SOC. APPL. PHYS. TOKYO, JAPAN, 1999, pages 29-30, XP002630039, ISBN: 4-930813-93-X

## Description

### Domaine technique de l'invention

L'invention concerne un procédé de fabrication d'un substrat comprenant une première zone active munie d'une surface principale en un premier matériau semi-conducteur, et une deuxième zone active munie d'une surface principale en un deuxième matériau semi-conducteur différent du premier matériau semi-conducteur.

### État de la technique

Un transistor MOS (MOS pour Metal Oxide Semiconductor), est constitué de deux réservoirs de porteurs de charges : la source et le drain, qui sont séparés par une barrière de potentiel formée par le canal. Cette barrière est contrôlée par une grille d'une longueur qui peut varier de plusieurs nanomètres à plusieurs dizaines de nanomètres. La grille est séparée du canal par un diélectrique de grille.

Afin d'augmenter la densité d'intégration dans les dispositifs microélectroniques, on cherche constamment à diminuer les dimensions critiques des transistors. Lorsque cette dimension est très faible, par exemple de l'ordre de plusieurs nanomètres ou dizaines de nanomètres, le contrôle électrostatique du canal n'est parfois plus assuré et la commande de la grille peut être dégradée : ce sont les effets de canaux courts.

Afin de continuer à augmenter la densité d'intégration, une première voie d'amélioration consiste à utiliser un substrat SOI (SOI pour « silicon on insulator »). Cette architecture particulière permet de mieux maîtriser l'isolation électrique du transistor en isolant la couche semi-conductrice active du substrat de support.

Une seconde voie d'amélioration consiste à introduire du germanium dans le canal. Le germanium qui présente la même structure cristalline que le silicium permet d'améliorer les performances électriques des transistors en offrant une meilleure mobilité des porteurs de charge surtout dans les transistors MOS de type p (pMOS). En effet, le germanium pur présente une mobilité deux fois plus importante pour les électrons et quatre fois plus importante pour les trous que le silicium.

Afin de tirer profit des avantages des substrats SOI et du germanium, l'industrie microélectronique a mis en œuvre des procédés de co-intégration sur des substrats SOI. Dans ces substrats, certains transistors (pMOS) ont des canaux en alliage de silicium-germanium (SiGe) et d'autres transistors (nMOS) ont des canaux en silicium. Il est intéressant de disposer d'un substrat qui comporte les deux types de matériaux semi-conducteurs.

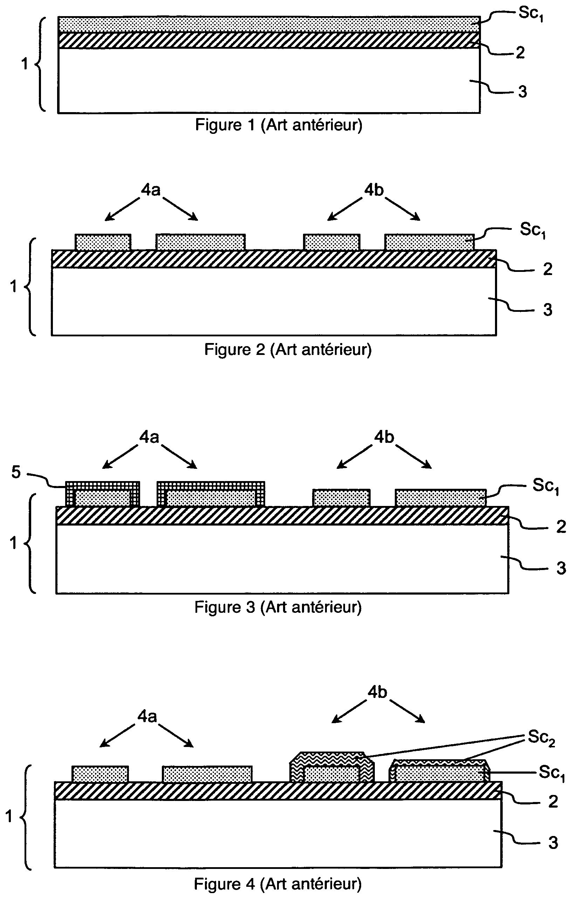

Un procédé conventionnel de co-intégration est illustré aux figures 1 à 4. La figure 1 illustre, de façon schématique, en coupe, un substrat de départ de type SOI, qui comporte un film en premier matériau semi-conducteur Sc₁, ici du silicium, disposé sur une couche d'un isolant électrique 2, ici l'oxyde de silicium (SiO₂), qui est, elle-même, disposée sur un support mécanique 3, ici en silicium.

Comme illustré à la figure 2, le substrat de type SOI est ensuite gravé de manière à obtenir plusieurs plots 4 en silicium qui constitueront les futures zones actives des transistors. Les plots 4 en silicium ont des tailles différentes, afin qu'ils puissent exercer des fonctions différentes.

Après la formation des plots 4 en silicium et comme illustré à la figure 3, une partie des plots 4 est couverte par un film d'oxyde de silicium 5, qui permet la différenciation des plots 4.

Comme illustré à la figure 4, un film de l'alliage silicium-germanium Sc₂ est ensuite déposé sur les plots en silicium Sc₁ découverts à l'aide d'une épitaxie sélective. L'épitaxie sélective est réalisée au moyen d'une chimie chlorée à base d'un mélange de dichlorosilane (SiH₂Cl₂), de germane (GeH₄) et d'acide chlorhydrique (HCl).

L'épitaxie sélective permet de déposer le film de silicium-germanium seulement dans les zones désirées. Il est alors nécessaire de laisser découvertes les zones où une croissance est recherchée et de recouvrir par un oxyde ou un nitrure de silicium les zones à protéger.

L'épitaxie sélective est une technique difficile à mettre en œuvre, à cause du nombre important de facteurs qui doivent être pris en considération lors de sa réalisation. Par ailleurs, l'épitaxie sélective engendre plusieurs problèmes technologiques liés notamment aux effets de charge et à la formation de « facettes ».

Les effets de charge surviennent au cours de l'épitaxie sélective en chimie chlorée et se traduisent par des fluctuations de la vitesse de croissance et de la concentration en germanium. Les effets de charge sont principalement liés à la quantité de surface active présente à la surface du substrat et à la répartition de ces surfaces actives sur le substrat. En effet, un même procédé de croissance utilisé pour différents circuits donnera des épaisseurs et des concentrations différentes dans la mesure où la quantité de silicium découverte est différente entre les deux circuits. De plus, entre les petites et les grandes zones ouvertes, des fluctuations en épaisseur et en teneur en germanium apparaissent dans les couches de silicium-germanium d'un même circuit. Il est donc impossible de garantir une homogénéité des propriétés (épaisseur, concentration en germanium et morphologie) des couches déposées par épitaxie sélective sur des plots en silicium de différentes tailles.

L'inhomogénéité des couches déposées par épitaxie sélective s'avère néfaste pour la suite des étapes technologiques d'intégration. En effet, les différences en épaisseur entre les zones actives sont préjudiciables notamment pour l'étape technologique de lithographie. Les fluctuations en concentration de germanium sont, par exemple, la cause d'une variabilité dans les propriétés électriques des transistors.

Au cours de l'épitaxie sélective un autre problème apparaît. Il est lié à la réduction de la surface effective des zones actives causée par la formation de « facettes » depuis les bords des zones actives. Lors de la croissance, des surfaces latérales parasites selon des plans cristallographiques donnés sont formées et réduisent la surface effective de la zone active, ce qui augmente les contraintes d'intégration.

Après le dépôt par épitaxie de l'alliage de silicium-germanium Sc₂ sur le film en silicium Sc₁, l'oxyde de silicium 5 qui a protégé les plots 4 est éliminé par voie chimique humide. Ainsi, le substrat obtenu comporte des plots 4a en silicium et des plots 4b munis d'un empilement (SiGe/Si). Les substrats obtenus sont par la suite utilisés dans des procédés conventionnels d'intégration de transistors MOS.

Le document US2007/0252216 décrit la fabrication d'un dispositif semi-conducteur où un substrat en Si est recouvert successivement par une couche en GaP et par une couche en Si. Une région de la couche en Si est éliminée afin de la remplacer par une couche en SiGe et définir deux zones actives avec des caractéristiques électriques différentes.

Le document EP 1 231 640 décrit un procédé de fabrication d'un dispositif semi-conducteur qui comporte la fourniture d'un substrat en SiC recouvert consécutivement par deux alternances de couches dopées de type n ou de type p et de couches non dopées. Une des alternances de couches est éliminée dans une zone active et conservée dans l'autre zone active afin de différencier les performances électriques entre les deux zones actives.

### Objet de l'invention

L'invention a pour but un procédé de réalisation d'un substrat muni de deux zones actives avec des matériaux semi-conducteurs différents qui soit facile à mettre en œuvre et qui réduit les contraintes technologiques sur la zone active formée par épitaxie.

Selon l'invention, ce but est atteint par le procédé divulgué par la revendication 1.

### Description sommaire des dessins

D'autres avantages et caractéristiques ressortiront plus clairement de la description qui va suivre de modes particuliers de réalisation de l'invention données à titre d'exemples non limitatifs et représentés aux dessins annexés, dans lesquels :
- les figure 1 à 4 représentent, de manière schématique, en coupe, des étapes successives d'un mode de réalisation d'un procédé selon l'art antérieur,
- les figures 5 à 8 représentent, de façon schématique, en coupe, des étapes successives d'un mode de réalisation d'un procédé selon l'invention,
- la figure 9 représente, de façon schématique, en coupe, une variante de réalisation d'un procédé selon l'invention ;
- les figures 10 et 11 représentent, de façon schématique, en coupe, deux substrats obtenus à partir du substrat illustré à la figure 8 ; et
- les figures 12 et 13, 14 et 15, 16 et 17 représentent, de façon schématique, en coupe, trois modes de réalisation de substrats particuliers obtenus à partir du substrat de la figure 11.

### Description d'un mode de réalisation préférentiel de l'invention

La figure 1 illustre, de manière schématique, en coupe, un substrat de départ 1 qui comporte au moins une couche en un premier matériau semi-conducteur monocristallin Sc₁ disposée à la surface d'un substrat de support 3. Le substrat de départ 1 peut également comporter des couches additionnelles en matériaux semi-conducteurs et des couches de nature différente.

Le substrat 1 est de type semi-conducteur sur isolant. Comme illustré à la figure 1, le substrat de départ 1 comporte une couche de support mécanique 3 et une couche en matériau électriquement isolant 2. La couche en premier matériau semi-conducteur Sc₁ est séparée de la couche de support mécanique 3 par le matériau électriquement isolant 2. Selon cette configuration, le premier matériau semi-conducteur Sc₁ peut être identique à celui de la couche de support mécanique 3 ou alors être un matériau différent. Le matériau semi-conducteur Sc₁ et la couche de support mécanique 3 peuvent également avoir la même orientation cristallographique ou des orientations différentes.

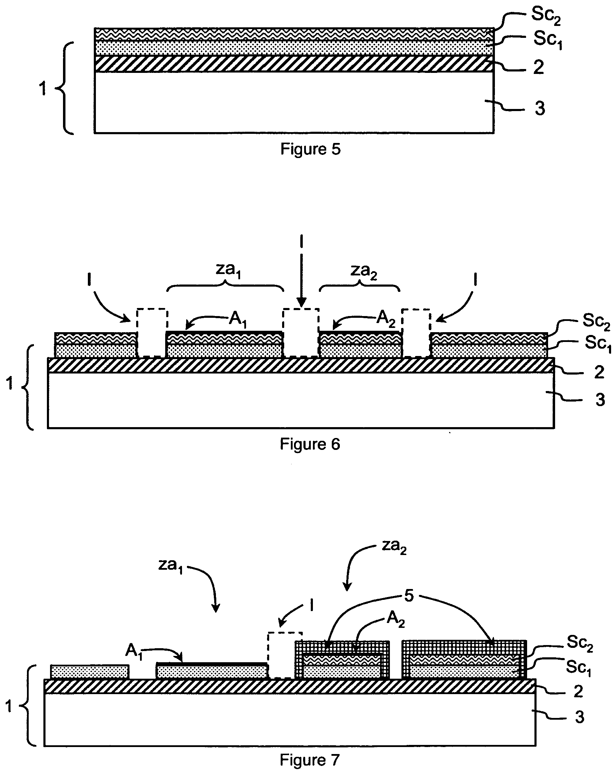

Le substrat 1 est de type semi-conducteur sur isolant. A titre d'exemple, le premier matériau semi-conducteur Sc₁ peut être à base de silicium, de germanium, d'alliage de silicium-germanium, dopés ou intrinsèques, relaxés ou contraints. De préférence, le premier matériau semi-conducteur Sc₁ est en silicium. La couche en matériau électriquement isolant est par exemple en oxyde de silicium (SiO₂). Elle peut également être formée par un empilement comportant plusieurs matériaux électriquement isolants. Comme illustré à la figure 5, au moins une couche en deuxième matériau semi-conducteur Sc₂ est déposée sur la couche en premier matériau semi-conducteur Sc₁. Le dépôt est effectué « pleine plaque » à l'aide d'une épitaxie, ce qui permet de s'affranchir des effets de charge et des « facettes » ou de les réduire. Le dépôt par épitaxie permet une prolongation de la maille cristalline de la couche en premier matériau semi-conducteur Sc₁ par la couche en deuxième matériau semi-conducteur Sc₂. De préférence, l'épitaxie est réalisée au moyen d'une chimie dite « non sélective », c'est-à-dire qui se dépose simultanément sur tous les matériaux présents. Si le semi-conducteur Sc₂ est un alliage de silicium germanium, l'épitaxie non sélective est réalisée de préférence à base d'une chimie hydrogénée comprenant par exemple du silane (SiH₄) et du germane (GeH₄). D'autres précurseurs gazeux ou liquides du silicium et du germanium peuvent être utilisés, par exemple, du disilane (Si₂H₆), du trisilane (Si₃H₈) ou du digermane (Ge₂H₆). Dans un mode de réalisation préférentiel, la couche en premier matériau semi-conducteur Sc₁ recouvre l'intégralité de la surface principale du substrat et elle est monocristalline. Il en résulte que le deuxième matériau semi-conducteur Sc₂ est également monocristallin et recouvre l'intégralité de la surface principale du substrat.

Comme il n'y a qu'un seul matériau avec une seule phase cristalline à la surface du substrat la même réaction a lieu sur le substrat et il n'y a pas de phénomène d'effet de charge. L'épitaxie est réalisée de préférence par dépôt chimique en phase vapeur, avantageusement à une pression comprise entre un centième et une atmosphère. Si le matériau Sc₂ est un alliage de silicium-germanium, une chimie chlorée (avec par exemple, du dichlorosilane (SiH₂Cl₂), du germane et de l'acide chlorhydrique gazeux (HCl)) peut également être utilisée pour ce dépôt « pleine plaque ».

Une succession de couches en matériaux semi-conducteurs peut également être formée, par épitaxie, entre les couches en premier et deuxième matériaux semi-conducteurs.

Le deuxième matériau semi-conducteur Sc₂ peut être à base de silicium, de germanium, d'alliage de silicium-germanium, dopé ou intrinsèque, relaxé ou contraint.

Dans un mode de réalisation préférentiel, le premier matériau semi-conducteur est en silicium et le deuxième matériau semi-conducteur est en silicium-germanium. Cependant, et indépendamment des matériaux semi-conducteurs choisis, le premier matériau semi-conducteur Sc₁ est différent du deuxième matériau semi-conducteur Sc₂.

Comme illustré à la figure 6, au moins deux zones actives za₁ et za₂ sont formées à la surface du substrat. Les zones actives sont formées par gravure du substrat au niveau des couches en premier et deuxième matériaux semi-conducteurs ce qui permet de définir des plots en saillie. À cette étape, les zones actives comportent une couche en premier matériau semi-conducteur Sc₁ recouverte par une couche en deuxième matériau semi-conducteur Sc₂. De ce fait, les surfaces principales des deux zones actives A₁ et A₂ sont formées par le même matériau, ici le deuxième matériau semi-conducteur Sc₂. La surface principale A d'une zone active est la surface libre parallèle à la surface du substrat 1. Comme les deux surfaces principales viennent de la même couche en deuxième matériau semi-conducteur, elles sont dans le même plan.

Dans un mode de réalisation particulier, la première zone active za₁ et la deuxième zone active za₂ sont séparées par une zone d'isolation I. De ce fait, les deux zones actives sont adjacentes et disjointes.

Dans un autre mode de réalisation les deux zones actives sont accolées et forment un seul et unique plot. Le dessin des plots est quelconque.

Comme illustré à la figure 7, la deuxième zone active za₂ est ensuite recouverte par un matériau de protection 5. La première zone active za₁ est laissée découverte. Puis le deuxième matériau semi-conducteur Sc₂ est éliminé de la première zone active za₁ découverte. Le matériau de protection 5 est choisi de manière à permettre la gravure sélective du deuxième matériau semi-conducteur Sc₂ vis-à-vis du matériau de protection 5 et, de préférence, vis-à-vis du premier matériau semi-conducteur Sc₁. À titre d'exemple, le procédé d'élimination du deuxième matériau semi-conducteur peut être un procédé comportant une étape de gravure plasma, en phase liquide ou en phase gazeuse. Si le matériau semi-conducteur Sc₂ est un alliage de silicium-germanium et le matériau Sc₁ est en silicium, on peut par exemple faire appel à une gravure plasma à base de CF₄, une gravure en phase liquide à base d'une solution d'acide fluorhydrique, d'acide nitrique et d'acide acétique dilués dans de l'eau dé-ionisé ou à une gravure thermique en phase gazeuse à l'aide d'acide chlorhydrique.

Le matériau de protection 5 peut être formé, par exemple, par un oxyde de silicium (SiO₂) ou un nitrure de silicium (Si₃N₄) ou à base d'un matériau photosensible comme une résine.

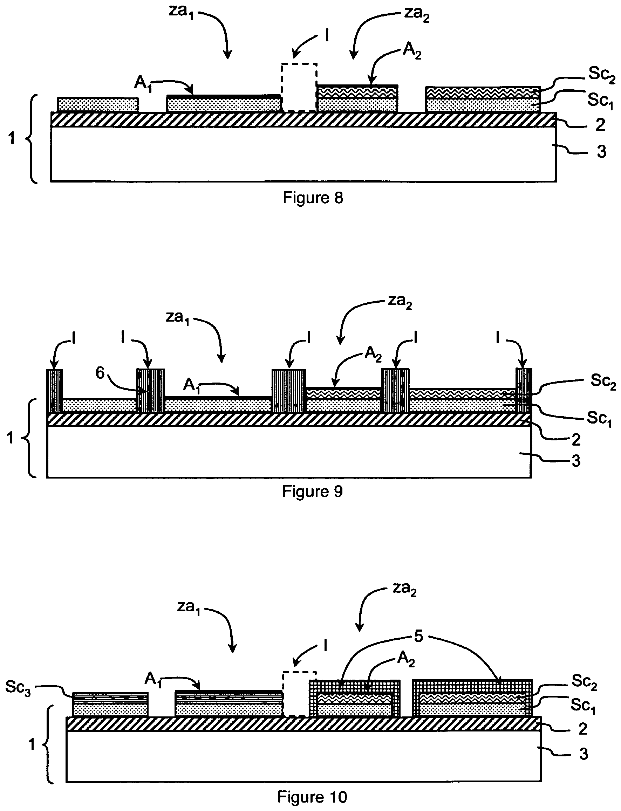

La figure 8 illustre la structure obtenue après l'élimination du matériau de protection 5 de manière à libérer la surface principale A₂ de la deuxième zone active za₂. Si nécessaire, les matériaux recouvrant le deuxième matériau semi-conducteur Sc₂ sont aussi éliminés à l'aide de procédés conventionnels.

Ainsi, une première zone active za₁ munie d'une surface principale A₁ en un premier matériau semi-conducteur Sc₁ et une deuxième zone active za₂ munie d'une surface principale A₂ en deuxième matériau semi-conducteur Sc₂ sont formées. Les deux zones actives za₁ et za₂ sont présentes à la surface du substrat et décalées latéralement l'une par rapport à l'autre.

De manière avantageuse, une zone d'isolation I sépare les deux zones actives. La zone d'isolation I peut être formée après différenciation des deux zones actives par gravure d'une portion de la première et/ou de la deuxième zone active pour former deux plots distincts et adjacents.

Dans un autre mode de réalisation, la zone d'isolation I est formée lors de la gravure des couches en premier et deuxième matériaux semi-conducteurs pour définir les plots en saillie de la structure illustrée à la figure 6. La zone d'isolation représente l'espace présent entre deux plots. La zone d'isolation I peut être formée soit par un vide (figure 8), soit par un matériau électriquement isolant 6 déposé après la structuration des zones actives za₁ et za₂ comme illustré à la figure 9. À titre d'exemple, le matériau électriquement isolant 6 peut être à base d'oxyde de silicium (SiO₂), ou de nitrure de silicium (Si₃N₄).

Ce procédé de réalisation est particulièrement avantageux car l'étape d'épitaxie formant le deuxième matériau semi-conducteur Sc₂ est réalisée avant la gravure du substrat pour délimiter les zones actives. Ainsi, il est possible d'utiliser une chimie de croissance plus facile à contrôler. Il est également plus facile de trouver une gravure sélective qu'une épitaxie sélective sans facettes.

Selon un mode complémentaire de réalisation et afin d'obtenir des surfaces principales A₁ et A₂ des deux zones actives définissant un même plan, un troisième matériau semi-conducteur Sc₃ est déposé sur la première zone active za₁ en premier matériau semi-conducteur Sc₁. Comme illustré à la figure 10, cette étape peut être effectuée avant l'élimination du matériau de protection 5 de la deuxième zone active Le troisième matériau semi-conducteur Sc₃ peut être identique au premier matériau semi-conducteur Sc₁, mais il peut également être différent. Le troisième matériau semi-conducteur Sc₃ est, de préférence, en silicium. Le dépôt du troisième matériau semi-conducteur Sc₃ sur la première zone active za₁ peut être effectué, par exemple, à l'aide d'une épitaxie sélective. Si le matériau Sc₃ est en silicium, les effets de charge seront minimisés.

Un autre mode de mise en œuvre du procédé permet également d'obtenir des surfaces principales A₁ et A₂ définissant un même plan en utilisant un dépôt « pleine plaque » du matériau Sc₃. Après la formation du bicouche Sc₂/Sc₁ sur le substrat 1, une élimination sélective du matériau Sc₂ est réalisée pour définir des zones comprenant un bicouche Sc₂/Sc₁ et des zones avec seulement la couche en matériau Sc₁. Cette élimination peut être réalisée, à l'aide d'une première photolithographie suivie d'une gravure. Ensuite, le masque qui a servi pour la photolithographie est éliminé et une couche du matériau Sc₃ est déposée pleine plaque. Les couches en matériaux Sc₂ et Sc₃ ont la même épaisseur. À l'aide d'une seconde photolithographie, cette fois-ci, d'une polarité opposée de la première, suivie d'une gravure du matériau Sc₃, on définit deux zones actives ayant des surfaces principales définissant un même plan. Une première zone active comprenant un bicouche Sc₂/Sc₁ et une deuxième zone active comprenant un bicouche Sc₃/Sc₁.

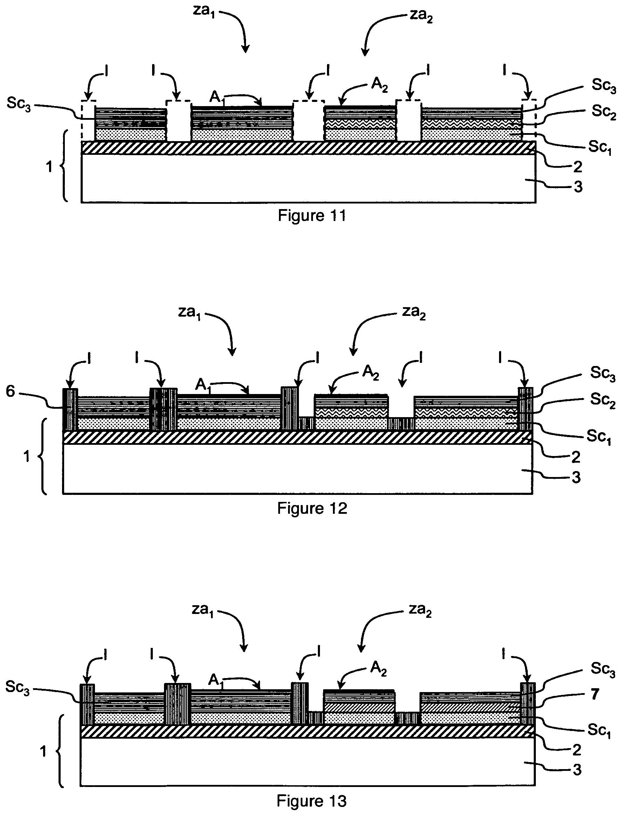

Selon un autre mode de réalisation, le troisième matériau semi-conducteur Sc₃ peut également être formé sur les zones actives za₁ et za₂ après élimination du matériau 5. Comme illustré à la figure 11, le substrat comporte une première zone active za₁ munie de surface principale A₁ en troisième matériau semi-conducteur Sc₃. La première zone active za₁ comporte une couche en premier matériau semi-conducteur Sc₁ recouverte par une couche en troisième matériau semi-conducteur Sc₃. Le substrat comporte également une deuxième zone active za₂ munie d'une surface principale A₂ en troisième matériau semi-conducteur Sc₃. La deuxième zone active za₂, comporte une couche en deuxième matériau semi-conducteur Sc₂ disposée entre deux couches en premier Sc₁ et troisième Sc₃ matériaux semi-conducteurs. Les deux zones actives za₁ et za₂ peuvent être séparées par une zone d'isolation I.

Le troisième matériau semi-conducteur Sc₃ peut être formé par tout moyen connu compatible avec le deuxième matériau semi-conducteur Sc₂, par exemple par épitaxie sélective. Cependant, quels que soient, le matériau et le moyen utilisés, le matériau semi-conducteur Sc₃ doit être différent du deuxième matériau semi-conducteur Sc₂.

Il est également envisageable de déposer directement un tricouche Sc₃/Sc₂/Sc₁ sur le substrat 1, puis de réaliser des éliminations successives des matériaux Sc₃ et Sc₂, suivies d'un dépôt du matériau Sc₃. Les étapes d'élimination peuvent utiliser des étapes de photolithographie avec différents jeux de masques qui permettront d'obtenir la structure illustrée à la figure 11.

Il est possible de combiner le mode de réalisation illustré à la figure 9 avec celui illustré à la figure 11 afin d'obtenir un mode de réalisation particulier qui comporte des première za₁ et deuxième za₂ zones actives ayant une surface principale en troisième matériau semi-conducteur Sc₃ et séparées par un motif d'isolation I.

Comme illustré à la figure 12, à partir du mode de réalisation particulier précédent, le motif d'isolation I est gravé à proximité de la deuxième zone active za₂ de manière à accéder latéralement à la couche en deuxième matériau semi-conducteur Sc₂. Cependant, la partie de la zone d'isolation I adjacente à la première zone active za₁ peut subsister et continuer à former une isolation pour la première zone active za₁. L'élimination du matériau électriquement isolant 6 peut être effectuée par tout moyen connu, par exemple en utilisant une étape de photolithographie suivie d'une gravure chimique.

Comme illustré à la figure 13, le deuxième matériau semi-conducteur Sc₂ est ensuite au moins partiellement éliminé et un matériau électriquement isolant additionnel 7 est déposé entre la couche en premier matériau semi-conducteur Sc₁ et la couche en troisième matériau semi-conducteur Sc₃. Le matériau électriquement isolant additionnel 7 peut être de la même nature que le matériau isolant 6 ou à base d'un matériau différent. Le matériau électriquement isolant additionnel 7 peut également être formé par un empilement comportant au moins un matériau électriquement isolant. Avantageusement, le matériau électriquement isolant additionnel 7 est à base d'un empilement d'Oxyde/Nitrure/Oxyde (ONO). Dans cette dernière configuration, le troisième matériau semi-conducteur Sc₃ est isolé électriquement du premier matériau semi-conducteur Sc₁ comme dans une structure SOI. Ce dernier mode de réalisation permet, avantageusement, un contrôle de l'épaisseur du matériau électriquement isolant 7 déposé. En effet, l'épaisseur de cette couche est définie par l'épaisseur de la couche en deuxième matériau Sc₂ déposée avec précision grâce à la technique d'épitaxie « pleine plaque ».

La localisation du matériau électriquement isolant 7 sous le troisième matériau semi-conducteur Sc₃ est réalisée de manière conventionnelle. La couche Sc₃ a la même orientation cristalline que la couche Sc₁.

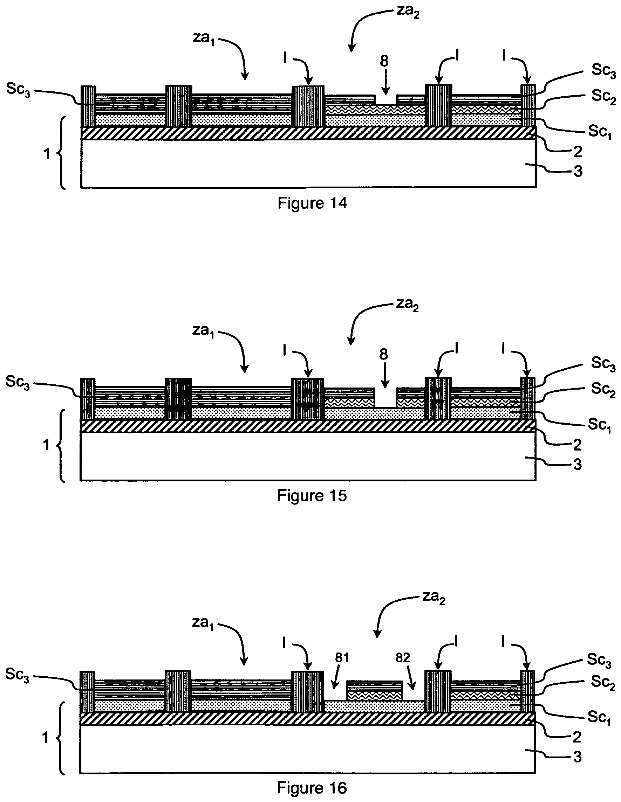

Une autre variante de réalisation permet d'obtenir une structure légèrement différente. Comme illustré à la figure 14, à partir de la zone active za₂ obtenue par le procédé illustré à la figure 11, un trou 8 peut être formé dans la couche en troisième matériau semi-conducteur Sc₃. La formation du trou 8 peut être effectuée par tout moyen connu d'élimination des matériaux semi-conducteurs et isolants, par exemple avec des techniques utilisant des étapes de photolithographie et de gravure chimique. Le trou 8 permet un accès à la couche en deuxième matériau semi-conducteur Sc₂ localisée sous la couche en troisième matériau semi-conducteur Sc₃. Comme illustré à la figure 15, le trou 8 peut également être prolongé dans la couche en deuxième matériau semi-conducteur Sc₂, de manière à augmenter la surface accessible de la couche en deuxième matériau semi-conducteur Sc₂.

De manière générale, le trou 8 est formé dans la deuxième zone active za₂ en réalisant une ouverture dans le matériau semi-conducteur de la surface principale A₂ de manière à accéder au deuxième matériau semi-conducteur Sc₂.

Comme illustré à la figure 16, deux zones vides, par exemple deux tranchées 81 et 82 peuvent également être formées de part et d'autre de la zone active Une électrode de grille peut être réalisée sur la deuxième zone active za₂ avant la formation des tranchées 81 et 82. La position de l'électrode de grille peut ainsi servir comme un masque et définir les tranchées 81 et 82. Ces dernières sont formées dans les couches en deuxième Sc₂ et troisième Sc₃ matériaux semi-conducteurs.

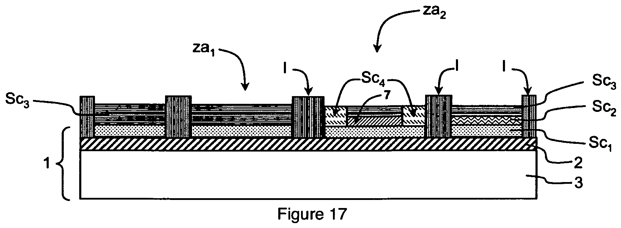

Ensuite, comme illustré à la figure 17, le deuxième matériau semi-conducteur Sc₂ est éliminé pour former une zone vide sous le troisième matériau semi-conducteur Sc₃ dans la deuxième zone active Les moyens d'élimination du deuxième matériau semi-conducteur Sc₂ sont semblables à ceux utilisés dans les modes de réalisation précédents. Un matériau électriquement isolant 7 est ensuite déposé entre la couche en premier matériau semi-conducteur Sc₁ et la couche en troisième matériau semi-conducteur Sc₃ dans la zone vide. De préférence, le matériau électriquement isolant 7 est formé par un empilement d'Oxyde/Nitrure/Oxyde (ONO). Après la formation d'une électrode de grille sur la deuxième zone active za₂, une délimitation du matériau électriquement isolant additionnel 7 sous cette électrode de grille, peut être effectuée. Un dépôt d'un matériau électriquement conducteur de part et d'autre du matériau électriquement isolant additionnel 7 est ensuite réalisé.

Suivant cette configuration, comme illustré à la figure 17, un dépôt de matériau semi-conducteur Sc₄, peut être effectué de manière à remplir les vides 81 et 82. Le matériau semi-conducteur Sc₄ peut être de même nature que Sc₁, Sc₂, Sc₃ ou à base d'un matériau semi-conducteur différent. De préférence les matériaux semi-conducteurs Sc₁ et Sc₄ sont de même nature. Après le remplissage des vides 81 et 82, par le matériau semi-conducteur Sc₄, ces zones peuvent être connectées électriquement au troisième matériau semi-conducteur Sc₃.

Les précédents modes de réalisation décrivent des étapes qui permettent la formation d'une première zone active za₁, et une deuxième zone active za₂ ayant des architectures différentes. Néanmoins, les mêmes modes de réalisation peuvent être appliqués afin de former simultanément une pluralité de premières zones actives et une pluralité de secondes zones actives. Les précédents modes de réalisation peuvent également être utilisés en combinaison afin de former une pluralité de zones actives ayant des surfaces et/ou des répartitions différentes. Comme l'étape d'épitaxie a lieu pleine plaque, les phénomènes d'effet de charge sont réduits ou nuls.

Tous les modes de réalisation de l'invention permettent d'éviter l'utilisation d'une épitaxie sélective pour déposer le deuxième matériau semi-conducteur Sc₂. Par conséquent, ces modes de réalisation permettent avantageusement d'obtenir une homogénéité de la morphologie des zones actives formées. L'épaisseur de la couche en deuxième matériau semi-conducteur Sc₂ déposée est également maîtrisée, ce qui est bénéfique pour la formation de zones actives munies de couches d'isolations enterrées dont les épaisseurs sont contrôlées avec précision.

## Revendications

1. Procédé de fabrication d'un substrat comprenant les étapes successives suivantes :
- prévoir un substrat (1) de type semi-conducteur sur isolant où le semiconducteur est une couche en premier matériau semi-conducteur (Sc₁) et l'isolant est une couche en matériau électriquement isolant (2) ;
- déposer, par épitaxie pleine plaque, une couche en deuxième matériau semi-conducteur (Sc₂) sur la couche en premier matériau semi-conducteur (Sc₁), le deuxième matériau semi-conducteur (Sc₂) étant différent du premier matériau semi-conducteur (Sc₁) ;
- graver la couche en premier matériau semi-conducteur (Sc₁) et la couche en deuxième matériau semi-conducteur (Sc₂) pour délimiter au moins deux zones actives, comprenant chacune les couches en premier (Sc₁) et deuxième (Sc₂) matériaux semi-conducteurs, les au moins deux zones actives étant au moins deux plots en saillie ;
- laisser une première zone active (za₁) découverte et recouvrir une deuxième zone active (za₂) par un matériau de protection (5) ; et
- éliminer la couche en deuxième matériau semi-conducteur (Sc₂) de la première zone active (za₁) de manière à obtenir une surface principale (A₁) en premier matériau semi-conducteur (Sc₁), la deuxième zone active (za₂) étant munie d'une surface principale (A₂) en deuxième matériau semi-conducteur (Sc₂) et comportant la couche en premier matériau semi-conducteur (Sc₁).

2. Procédé selon la revendication 1 **caractérisé en ce qu'**il comporte un dépôt d'un troisième matériau semi-conducteur (Sc₃), différent du deuxième matériau semi-conducteur (Sc₂), sur les zones actives après l'élimination du matériau de protection (5) de la deuxième zone active (za₂).

3. Procédé selon la revendication 1 **caractérisé en ce qu'**il comporte un dépôt d'un troisième matériau semi-conducteur (Sc₃) sur la première zone active (za₁) avant l'élimination du matériau de protection (5) de la deuxième zone active (za₂) de manière à avoir les surfaces principales des première (A₁) et deuxième (A₂) zones actives dans un même plan.

4. Procédé selon la revendication 2 ou 3 **caractérisé en ce qu'**il comporte la formation dans la deuxième zone active (za₂), d'un trou (8) ouvert dans le troisième matériau semi-conducteur (SC3) de manière à accéder au deuxième matériau semi-conducteur (Sc₂).

5. Procédé selon l'une quelconque des revendications 1 à 4 **caractérisé en ce qu'**il comporte un dépôt d'un matériau électriquement isolant (6) entre les première (za₁) et deuxième (za₂) zones actives pour former un motif d'isolation (I).

6. Procédé selon la revendication 5, dans la mesure où elle est directement dépendante de la revendication 2 ou 3, **caractérisé en ce qu'**on grave le motif d'isolation (I) de manière à accéder latéralement à la couche en deuxième matériau semi-conducteur (Sc₂) de la deuxième zone active (za₂).

7. Procédé selon la revendication 4 ou la revendication 6, **caractérisé en ce qu'**il comporte :
- L'élimination de la couche en deuxième matériau semi-conducteur (Sc2) dans la deuxième zone active (za₂) pour former une zone vide ;
- Le dépôt d'un matériau électriquement isolant additionnel (7) dans la zone vide.

8. Procédé selon la revendication 7 **caractérisé en ce qu'**il comporte :
- la formation d'une électrode de grille sur la deuxième zone active (za2) ;
- la délimitation du matériau électriquement isolant additionnel (7) sous l'électrode de grille ; et
- le dépôt d'un matériau électriquement conducteur de part et d'autre du matériau électriquement isolant additionnel (7).

## Patentansprüche

1. Verfahren zur Herstellung eines Substrats, das die folgenden aufeinanderfolgenden Schritte umfasst:
- Bereitstellen eines Substrats vom Halbleitertyp (1) auf Isolierung, wobei der Halbleiter eine Schicht aus einem ersten Halbleitermaterial (Sc₁) ist, und die Isolierung eine Schicht aus elektrisch isolierendem Material ist;
- Aufbringen durch plattendeckende Epitaxie einer Schicht aus einem zweiten Halbleitermaterial (Sc₂) auf der Schicht aus erstem Halbleitermaterial (Sc₁), wobei das zweite Halbleitermaterial (Sc₂) von dem ersten Halbleitermaterial (Sc₁) unterschiedlich ist;
- Ätzen der Schicht aus erstem Halbleitermaterial (Sc₁) und der Schicht aus zweitem Halbleitermaterial (Sc₂), um mindestens zwei aktive Zonen abzugrenzen, die jeweils die Schichten aus erstem (Sc₁) und zweitem (Sc₂) Halbleitermaterial aufweisen, wobei die mindestens zwei aktiven Zonen zumindest zwei vorragende Pads sind;
- Abgedecktlassen einer ersten aktiven Zone (za₁) und Abdecken einer zweiten aktiven Zone (za₂) durch ein Schutzmaterial (5); und
- Beseitigen der Schicht aus zweitem Halbleitermaterial (Sc₂) von der ersten aktiven Zone (za₁) derart, dass eine Hauptoberfläche (A₁) aus erstem Halbleitermaterial (Sc₁) erhalten wird, wobei die zweite aktive Zone (za₂) mit einer Hauptoberfläche (A₂) aus zweitem Halbleitermaterial (Sc₂) versehen ist und die Schicht aus erstem Halbleitermaterial (Sc₁) umfasst.

2. Verfahren nach Anspruch 1, **dadurch gekennzeichnet, dass** es eine Ablagerung aus einem dritten Halbleitermaterial (Sc₃), das von dem zweiten Halbleitermaterial (Sc₂) unterschiedlich ist, auf den aktiven Zonen nach dem Beseitigen des Schutzmaterials (5) von der zweiten aktiven Zone (za₂) umfasst.

3. Verfahren nach Anspruch 1, **dadurch gekennzeichnet, dass** es eine zusätzliche Ablagerung des dritten Halbleitermaterials (Sc₃) auf der ersten aktiven Zone (za₁) vor dem Beseitigen des Schutzmaterials (5) von der zweiten aktiven Zone (za₂) derart umfasst, dass die Hauptoberflächen der ersten (A₁) und zweiten (A₂) aktiven Zone in einer selben Ebene sind.

4. Verfahren nach einem der Ansprüche 2 oder 3, **dadurch gekennzeichnet, dass** es das Bilden in der zweiten aktiven Zone (za₂) eines Lochs (8) umfasst, das in dem dritten Halbleitermaterial (Sc₃) der Hauptoberfläche (A₂) derart offen ist, dass auf das zweite Halbleitermaterial (Sc₂) zugegriffen wird.

5. Verfahren nach einem der Ansprüche 1 bis 4, **dadurch gekennzeichnet, dass** es eine Ablagerung aus einem elektrisch isolierenden Material (6) zwischen der ersten (za1) und der zweiten (za₂) aktiven Zone umfasst, um ein Isoliermuster (I) zu bilden.

6. Verfahren nach Anspruch 5, insofern als er direkt von dem Anspruch 2 oder von dem Anspruch 3 abhängig ist, **dadurch gekennzeichnet, dass** das Isoliermuster (I) derart geätzt wird, dass seitlich auf die Schicht aus zweitem Halbleitermaterial (Sc₂) der zweiten aktiven Zone (za₂) zugegriffen wird.

7. Verfahren nach Anspruch 4 oder nach Anspruch 6, **dadurch gekennzeichnet, dass** es Folgendes umfasst:
- Beseitigen der Schicht aus zweitem Halbleitermaterial (Sc₂) in der zweiten aktiven Zone (za₂), um eine leere Zone zu bilden;
- Ablagern eines zusätzlichen elektrisch isolierenden Materials (7) in der leeren Zone.

8. Verfahren nach Anspruch 7, **dadurch gekennzeichnet, dass** es Folgendes umfasst:
- Bilden einer Gate-Elektrode auf der zweiten aktiven Zone (za₂);
- Abgrenzen des zusätzlichen elektrisch isolierenden Materials (7) unter der Gate-Elektrode; und
- Ablagern eines elektrisch leitenden Materials zu beiden Seiten des zusätzlichen elektrisch isolierenden Materials (7) .

## Claims

1. Method for fabricating a substrate comprising the following successive steps:
- providing a substrate (1) of semiconductor on insulator type where the semiconductor is a layer made from first semiconductor material (Sc₁) and the insulator is a layer made from electrically insulating material (2);
- depositing a layer made from second semiconductor material (Sc₂) by full wafer epitaxy on the layer made from first semiconductor material (Sc₁), the second semiconductor material (Sc₂) being different from the first semiconductor material (Sc₁);
- etching the layer made from first semiconductor material (Sc₁) and the layer made from second semi-conductor material (Sc₂) to delineate at least two active areas each comprising layers of first semiconductor material (Sc₁) and of second semi-conductor material (Sc₂), the at least two active areas being at least two salient bumps;
- leaving a first active area (za₁) uncovered and covering a second active area (za2) with a protective material (5); and
- removing the layer made from second semiconductor material (Sc₂) of the first active area (za₁) so as to obtain a main surface (A₁) made from first semi-conductor material (Sc₁), the second active area (za₂) comprising a main surface (A₂) made from second semiconductor material (Sc₂) and the layer made from first semiconductor material (Sc₁).

2. Method according to claim 1, **characterized in that** it comprises deposition of a third semiconductor material (Sc₃), different from the second semiconductor material (Sc₂), on the active areas after the protective material (5) of the second active area (za₂) has been removed.

3. Method according to claim 1, **characterized in that** it comprises deposition of a third semiconductor material (Sc₃) on the first active area (za₁) before removal of the protective material (5) from the second active area (za₂) so as to have the main surfaces of the first active area (A₁) and of the second active area (A₂) in the same plane.

4. Method according to claim 2 or 3, **characterized in that** it comprises formation of an open hole (8) in the third semiconductor material (Sc₃), in the second active layer (za₂), so as to access the second semiconductor material (Sc₂).

5. Method according to any one of claims 1 to 4, **characterized in that** it comprises deposition of an electrically insulating material (6) between the first active area (za₁) and the second active area (za₂) to form an insulating pattern (I)

6. Method according to claim 5, in so far as it is directly dependent on claim 2 or 3, **characterized in that** it the insulating pattern (I) is etched so as to laterally access the layer made from second semiconductor material (Sc₂) of the second active area (za2).

7. Method according to claim 4 or according to claim 6, **characterized in that** it comprises:
- removal of the layer made from second semiconductor material (Sc₂) in the second active area (za₂) to form a void area;
- deposition of an additional electrically insulating material (7) in the void area.

8. Method according to claim 7, **characterized in that** it comprises:
- formation of a gate electrode on the second active area (za₂);
- delineation of the additional electrically insulating material (7) underneath the gate electrode; and
- deposition of an electrically conducting material on each side of the additional electrically insulating material (7).
